Europäisches Patentamt

European Patent Office

Office européen des brevets

(19)

(11) Numéro de publication : **0 141 698**
**B1**

(12) # FASCICULE DE BREVET EUROPÉEN

(45) Date de publication du fascicule du brevet :
02.12.87

(51) Int. Cl.⁴ : **H 03 K 17/30**

(21) Numéro de dépôt : 84401796.2

(22) Date de dépôt : 12.09.84

(54) **Circuit de détection de courant à faible dissipation de puissance active et circuit de commande d'un dispositif électronique équipé d'un tel circuit de détection.**

(30) Priorité : 14.09.83 FR 8314597

(43) Date de publication de la demande :
15.05.85 Bulletin 85/20

(45) Mention de la délivrance du brevet :
02.12.87 Bulletin 87/49

(84) Etats contractants désignés :
**AT BE CH DE GB IT LI LU NL SE**

(56) Documents cités :
**EP-A- 0 109 227
FR-A- 1 597 880
IBM TECHNICAL DISCLOSURE BULLETIN, volume
23, no. 11, avril 1981, (NEW YORK, US) P.S. KOVACH:
"Current sensor", pages 4898-4899**

(73) Titulaire : **SYRELEC**
**B.P. no. 3 Zone Industrielle**
**F-14540 Bourguebus (FR)**

(72) Inventeur : **Marie, Jean-Louis, André, Auguste**
**6 rue de la Libération Soliers**
**F-14540 Bourguebus (FR)**

(74) Mandataire : **Chameroy, Claude et al**
**c/o Cabinet Malemont 42, avenue du Président Wilson**
**F-75116 Paris (FR)**

## Description

La présente invention se rapporte à un circuit de détection de courant, utilisable notamment pour l'élimination des courants ou tensions de fuite à l'entrée d'un dispositif électronique, ce circuit de détection de courant comprenant un circuit basculant alimenté par une tension alternative fonction du courant à détecter et commandant l'entrée de comparaison d'un comparateur.

On sait qu'à l'entrée de certains dispositifs électroniques, peuvent apparaître au repos des courants ou tensions de fuite dont il est nécessaire de s'affranchir.

C'est ainsi que, dans le cas d'une minuterie électronique, commandée par l'intermédiaire d'un commutateur à voyant lumineux, un courant de fuite pouvant atteindre plusieurs dizaines de mA circule à travers le voyant lumineux en position ouverte du bouton-poussoir.

Pour s'affranchir de ce courant de fuite, il est d'usage d'insérer entre le commutateur et l'entrée de commande de la minuterie, un circuit de détection de courant du type spécifié en préambule, qui doit en outre éliminer le courant de fuite en dégageant le minimum de chaleur, cette condition étant requise dans la mesure où les minuteries sont le plus souvent montées dans des boîtiers en matière plastique.

Pour satisfaire cette condition, on utilise à l'heure actuelle des circuits de détection de courant dont le circuit basculant est conçu à partir d'un composant principal à faible dissipation de puissance active, tel qu'un condensateur ayant une tension maximum élevée ou une thermistance à coefficient de température positif (CTP) dont le courant de basculement doit être supérieur au courant de fuite. On sait toutefois que ces composants spéciaux sont soit très coûteux, soit trop volumineux vis-à-vis des dimensions imposées aux boîtiers des minuteries électroniques.

La présente invention se propose de remédier à ces inconvénients et, pour ce faire, elle a pour objet un circuit de détection de courant du type spécifié en préambule, qui se caractérise en ce que le circuit basculant comprend, connectés successivement en série entre ses première et deuxième bornes d'alimentation, une diode, une première résistance de faible valeur ohmique par rapport à la valeur ohmique de l'impédance interne de la source de tension alternative alimentant le circuit basculant et un redresseur contrôlé à semi-conducteur placé dans le même sens de conduction que la diode et commandé par la sortie d'un inverseur, sur l'entrée duquel est appliquée la tension aux bornes de la première résistance, au travers d'un circuit abaisseur de tension dont la sortie est connectée à l'entrée de comparaison du comparateur.

Dans un mode de réalisation préféré de l'invention, le redresseur contrôlé à semi-conducteur est un thyristor.

Selon un autre mode de réalisation particulier de l'invention, le circuit abaisseur de tension est constitué par un pont résistif, formé d'une deuxième et d'une troisième résistances de valeurs ohmiques élevées, connectées en série entre le point de connexion de la diode avec la première résistance et la deuxième borne d'alimentation.

Le circuit de détection de courant selon l'invention comprend en outre un condensateur monté en parallèle sur la troisième résistance.

Enfin, une résistance de protection peut être prévue entre la sortie de l'inverseur et l'entrée de commande du redresseur contrôlé à semi-conducteur.

On dispose ainsi, grâce à l'invention, d'un circuit de détection de courant qui ne fait appel qu'à des composants grand public, qui sont peu coûteux et réduisent au maximum l'encombrement du circuit de détection dans son ensemble.

Le circuit de détection de courant selon l'invention peut être avantageusement utilisé pour l'élimination des courants ou tensions de fuite à l'entrée d'un dispositif électronique, en particulier une minuterie électronique, alimenté par une source de tension alternative par l'intermédiaire d'un commutateur, auquel cas il est inséré entre le commutateur et l'entrée de commande du dispositif électronique, ledit commutateur étant branché en parallèle sur la source de tension alternative à haute impédance interne.

Dans cette application, le circuit de détection de courant, bien qu'étant essentiellement constitué par des composants résistifs, dissipe très peu de chaleur par effet Joule grâce au montage particulier de son circuit basculant, tel que proposé par l'invention.

On comprendra en effet que, dans ce circuit basculant, la chute de tension aux bornes de la première résistance est soit très élevée (cas où elle est égale à la tension d'alimentation lorsque le commutateur est fermé), soit très faible (cas où le commutateur est ouvert mais court-circuité par le circuit de fuite).

Dès lors, dans le premier cas, le redresseur contrôlé à semi-conducteur se bloque, ce qui fait que la puissance active énorme développée par la première résistance est instantanément dissipée. Dans le second cas par contre, il devient conducteur, mais la puissance dissipée en permanence par la première résistance est alors très faible. Cela se traduit dans les deux cas par une très faible dissipation de chaleur du circuit de détection de courant selon l'invention, ce qui fait que ce dernier offre les mêmes avantages que les circuits de détection de courant connus à condensateur ou à thermistance CTP sans présenter les inconvénients d'un coût élevé ou d'un encombrement trop important.

Il est encore à noter que le circuit de détection de courant selon l'invention est équipé de moyens de remise à l'état initial de la sortie de son circuit basculant, moyens qui peuvent avantageusement consister en un oscillateur dont la sortie est reliée à l'entrée de l'inverseur.

Un mode de réalisation de la présente invention va maintenant être décrit à titre d'exemple non limitatif en référence au dessin annexé dont la figure unique représente le schéma d'un circuit de commande d'une minuterie électronique, renfermant un circuit de détection de courant conforme à l'invention.

Dans ce circuit de commande, le circuit de détection de courant 1 objet de l'invention, est relié au secteur par un bouton-poussoir 2 sur lequel sont montés en parallèle un ou plusieurs voyants lumineux 3, présentant une résistance équivalente de l'ordre de 4,7 k$\Omega$.

Plus précisément, un premier pôle $B_1$ du bouton-poussoir 2 est connecté à la phase P tandis que son deuxième pôle $B_2$ est relié à une première borne d'alimentation $A_1$ du circuit de détection 1 dont la deuxième borne d'alimentation $A_2$ est raccordée au neutre N.

Selon la caractéristique première de l'invention, le circuit de détection 1 comprend une diode $D_1$, branchée dans le sens de passage des alternances positives, entre la première borne d'alimentation $A_1$ et une première résistance $R_1$ ayant une faible valeur ohmique de l'ordre de 470 $\Omega$, la deuxième borne de cette résistance $R_1$ étant connectée à l'anode d'un thyristor T dont la cathode est raccordée à la deuxième borne d'alimentation $A_2$.

Entre le point de connexion de la diode $D_1$ avec la résistance $R_1$ et la deuxième borne d'alimentation $B_2$, est connecté un pont résistif formé d'une deuxième et d'une troisième résistances $R_2$, $R_3$ de valeurs ohmiques élevées respectivement de 220 et 33 K$\Omega$, ce pont résistif constituant un circuit abaisseur de la tension aux bornes de la première résistance $R_1$.

Au point milieu de ce pont résistif, est reliée l'entrée d'un inverseur de niveau logique I, dont la sortie est connectée, au travers d'une résistance de protection $R_4$, à la gâchette du thyristor T.

Le point milieu du pont résistif $R_2$, $R_3$ est en outre relié à l'entrée de comparaison + d'un comparateur 4 dont l'entrée de référence — reçoit la tension de référence $V_{REF}$, la sortie de ce comparateur 4 étant raccordée à l'entrée de commande du circuit de la minuterie non représentée.

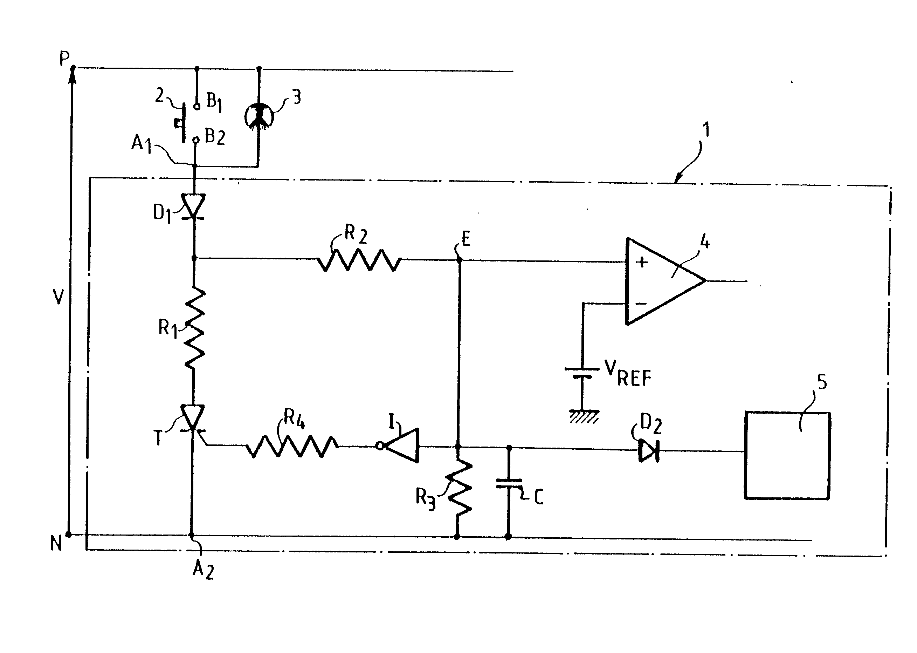

On observera encore sur la figure 1 qu'un condensateur C d'environ 1 $\mu$F est connecté en parallèle sur la troisième résistance $R_3$ et que l'entrée de l'inverseur I est reliée, au travers d'une deuxième diode $D_2$ montée en inverse à la sortie d'un oscillateur 5.

Le circuit de commande, qui vient d'être décrit, a pour fonction d'éliminer le courant de fuite, de l'ordre de 50 mA, qui traverse le voyant lumineux 3 lorsque le bouton-poussoir 2 est ouvert.

Dans ce circuit de commande, le circuit de détection 1 selon l'invention agit de la manière suivante.

Si le bouton-poussoir 2 est en position ouverte, la tension d'alimentation secteur V se retrouve presque entièrement aux bornes du voyant lumineux 3, étant donné que celui-ci équivaut à une résistance de valeur ohmique dix fois supérieure à celle de la résistance $R_1$.

Dès lors, la chute de tension aux bornes de la résistance $R_1$ est très faible et le signal E, qui apparaît sur le point milieu du pont résistif $R_2$, $R_3$ est à un niveau minimum équivalent à un « 0 » logique.

Il s'ensuit que le comparateur 4 ne délivre aucune impulsion à l'entrée de commande du circuit de la minuterie.

Par ailleurs, l'inverseur délivre un signal de niveau « 1 » qui, étant appliqué sur la gâchette du thyristor T, place et maintient ce dernier dans son état de conduction jusqu'à ce que la gâchette reçoive un signal de niveau « 0 ». Pendant ce temps, la résistance $R_1$ soumise à l'application d'une tension très faible, dissipe en permanence une puissance active pratiquement négligeable.

Si maintenant, on enfonce le bouton-poussoir 2, la tension d'alimentation secteur V s'applique entièrement aux bornes de la résistance $R_1$ en faisant basculer le signal E au niveau logique « 1 ». Le comparateur 4 recevant ce niveau « 1 » sur son entrée de comparaison génère une impulsion appliquée à l'entrée de commande du circuit de la minuterie qui est ainsi activé.

Dans le même temps, l'inverseur I génère un signal de niveau « 0 », si bien que le thyristor T se bloque à l'alternance négative suivante.

Il s'ensuit que la résistance $R_1$ dissipe une puissance active énorme, au maximum égale à 70 W, mais seulement pendant une période très courte de 30 ms toutes les secondes, déterminée par la constante de temps du circuit de décharge constitué par la deuxième résistance $R_2$ et le condensateur C. En conséquence, dans le cas où le bouton-poussoir 2 reste fermé en permanence, le circuit de détection de courant selon l'invention ne dissipe qu'une puissance moyenne de 2 W.

Il est encore à noter que dans le fonctionnement de ce circuit, l'oscillateur 5 intervient pour replacer dans son niveau initial le signal E, en déchargeant instantanément le condensateur C pendant un temps très court. Ainsi, si après avoir été enfoncé, le bouton-poussoir 2 revient en position ouverte, le signal E repasse à son niveau « 0 », mais si le bouton-poussoir reste fermé, il est maintenu au niveau « 1 ».

Il va de soi que diverses modifications, restant dans le cadre de la présente invention, peuvent être apportées au circuit de détection qui vient d'être décrit. C'est ainsi que le pont résistif $R_2$, $R_3$ peut être remplacé par tout autre circuit abaisseur de tension et qu'un triac ou autre redresseur contrôlé à semi-conducteur peut remplir la fonction du thyristor T.

Il est bien évident aussi que l'on peut utiliser le circuit de détection de courant selon l'invention pour s'affranchir des courants ou tensions de fuite apparaissant à l'entrée de tout dispositif électronique autre qu'une minuterie. Le circuit de détection de courant selon l'invention peut même avoir d'autres applications.

On ajoutera encore que les valeurs des caractéristiques des composants apparaissant dans la description ci-dessus ne sont données qu'à titre purement indicatif.

**Revendications**

1. Circuit de détection de courant, utilisable notamment pour l'élimination des courants ou tensions de fuite à l'entrée d'un dispositif électronique, ce circuit de détection de courant comprenant un circuit basculant alimenté par une source de tension alternative, fonction du courant à détecter, et commandant l'entrée de comparaison d'un comparateur caractérisé en ce que le circuit basculant comprend, connectés successivement en série entre ses première et deuxième bornes d'alimentation ($A_1$, $A_2$), une diode ($D_1$), une première résistance ($R_1$) de faible valeur ohmique par rapport à la valeur ohmique de l'impédance interne de ladite source, et un redresseur contrôlé à semi-conducteur (T) placé dans le même sens de conduction que la diode et commandé par la sortie d'un inverseur (I), sur l'entrée duquel est appliquée la tension aux bornes de la première résistance ($R_1$), au travers d'un circuit abaisseur de tension dont la sortie est connectée à l'entrée de comparaison du comparateur (4).

2. Circuit de détection de courant selon la revendication 1, caractérisé en ce que le redresseur contrôlé à semi-conducteur est un thyristor (T).

3. Circuit de détection de courant selon la revendication 1 ou 2, caractérisé en ce que le circuit abaisseur de tension est constitué par un pont résistif formé d'une deuxième et d'une troisième résistances ($R_2$, $R_3$) de valeurs ohmiques élevées, connectées en série entre le point de connexion de la diode ($D_1$) avec la première résistance ($R_1$) et la deuxième borne d'alimentation ($A_1$).

4. Circuit de détection de courant selon la revendication 3 caractérisé en ce qu'un condensateur (C) est monté en parallèle sur la troisième résistance ($R_3$).

5. Circuit de détection de courant selon l'une quelconque des revendications 1 à 4, caractérisé en ce qu'une quatrième résistance relie la sortie de l'inverseur (I) à l'entrée de commande du redresseur contrôlé à semi-conducteur (T).

6. Circuit de détection de courant selon l'une quelconque des revendications 1 à 5, caractérisé en ce qu'il comprend des moyens pour remettre à son état initial le signal (E) prélevé sur la sortie du circuit abaisseur de tension ($R_2$, $R_3$).

7. Circuit de détection de courant selon la revendication 6, caractérisé en ce que lesdits moyens de remise à l'état initial sont constitués par un oscillateur (5) dont la sortie est connectée à l'entrée de l'inverseur (I).

8. Circuit de commande d'un dispositif électronique, et notamment d'une minuterie électronique, comprenant un circuit de détection (1) de courant tel que défini par l'une quelconque des revendications 1 à 7 et dans lequel le circuit basculant est connecté, par l'intermédiaire d'un commutateur (2), aux bornes de la source d'alimentation du dispositif électronique, la sortie du comparateur (4) étant reliée à l'entrée de commande de ce dernier, ledit commutateur étant branché en parallèle sur ladite source de tension alternative à haute impédance interne.

**Claims**

1. A current detection circuit, adapted notably to the elimination of stray currents or voltages at the input to an electronic device, the said current detection circuit comprising a tripping circuit supplied from a source of alternating voltage dependant on the current to be detected, and controlling the comparison input of a comparator, characterized in that the tripping circuit includes, in series connection between its first and second supply terminals ($A_1$, $A_2$), a diode ($D_1$), a first resistor ($R_1$) of low ohmic value compared with the ohmic value of the internal impedance of the said source, and a controlled semiconductor rectifier (T) conductive in the same direction as the diode and controlled by the output from an inverter (I), to the input of which the voltage, present across the first resistor ($R_1$), is applied through a voltage reduction circuit the output of which is connected to the comparison input of the comparator (4).

2. A current detection circuit as in Claim 1, characterized in that the controlled semiconductor rectifier is a thyristor (T).

3. A current detection circuit as in Claim 1 or 2, characterized in that the voltage reduction circuit consists of a resistance bridge formed by second and third resistors ($R_2$, $R_3$), both of high ohmic value, connected in series between the point of connection of the diode ($D_1$) to the first resistor ($R_1$) and the second supply terminal ($A_1$).

4. A current detection circuit as in Claim 3, characterized in that a capacitor (C) is inserted in parallel with the third resistor ($R_3$).

5. A current detection circuit as in any of Claims 1 to 4, characterized in that a fourth resistor connects the output of the inverter (I) to the control input of the controlled semiconductor rectifier (T).

6. A current detection circuit as in any of Claims 1 to 5, characterized in that it incorporates means to return to its initial state the signal (E) taken on the output from the voltage reduction circuit ($R_2$, $R_3$).

7. A current detection circuit as in Claim 6, characterized in that the said means of returning to the initial state consist of an oscillator (5) the output of which is connected to the input of the inverter (I).

8. A control circuit for an electronic device, notably for an electronic time switch, comprising a current detection circuit (1) as specified in any of Claims 1 to 7 and in which the tripping circuit is connected through a switch (2) to the terminals of the source supplying the electronic device, the output of the comparator (4) being connected to the control input of the device, and the said switch being connected in parallel across the said alternating voltage source of high internal impedance.

**Patentansprüche**

1. Stromdetektorschaltung, insb. zur Beseitigung der Kriech-Ströme oder -Spannungen am Eingang einer elektronischen Einrichtung, wobei die Stromdetektorschaltung eine durch eine Wechselspannungsquelle gespeiste Kippschaltung enthält, die eine Funktion des zu erfassenden Stromes ist, und den Vergleichseingang eines Komparators steuert, dadurch gekennzeichnet, daß die Kippschaltung folgende Bauelemente in Serie zwischen ihren ersten und zweiten Anschlußklemmen (A1, A2) aufweist : eine Diode (D1), einen ersten Widerstand mit einem im Vergleich zum ohmschen Wert der internen Impedanz der Wechselspannungsquelle niedrigen ohmschen Wert, und einen gesteuerten Halbleitergleichrichter (T) in gleicher Durchgangsrichtung gepolt wie die Diode und durch den Ausgang eines Umschalters (I) gesteuert, an dessen Eingang die Spannung an den Klemmen des ersten Widerstandes (R1) durch eine Spannungsteiler-Schaltung angelegt wird, deren Ausgang mit dem Vergleichseingang des Komparators (4) verbunden ist.

2. Stromdetektorschaltung nach Anspruch 1, dadurch gekennzeichnet, daß der gesteuerte Halbleitergleichrichter ein Thyristor (T) ist.

3. Stromdetektorschaltung nach Anspruch 1 oder 2, dadurch gekennzeichnet, daß die Spannungsteiler-Schaltung aus einer durch einen zweiten und einen dritten Widerstand (R2, R3) mit hohen ohmschen Werten gebildeten Widerstandsbrücke besteht, die in Serie zwischen dem Verbindungspunkt der Diode (D1) mit dem ersten Widerstand (R1) und der zweiten Anschlußklemme (A1) geschaltet sind.

4. Stromdetektorschaltung nach Anspruch 3, dadurch gekennzeichnet, daß ein Kondensator (C) parallel zum dritten Widerstand (R3) geschaltet ist.

5. Stromdetektorschaltung nach einem der Ansprüche 1 bis 4, dadurch gekennzeichnet, daß ein vierter Widerstand den Ausgang des Umschalters (I) mit dem Steuereingang des gesteuerten Halbleiter-Gleichrichter (T) verbindet.

6. Stromdetektorschaltung nach einem der Ansprüche 1 bis 5, dadurch gekennzeichnet, daß sie Mittel beinhaltet, um das Signal (E) in seinen Ursprungszustand zurückzubringen, das am Ausgang der Spannungsteiler-Schaltung (R2, R3) entnommen wird.

7. Stromdetektorschaltung nach Anspruch 6, dadurch gekennzeichnet, daß die Mittel, die das Signal (E) in seinen Ursprungszustand zurückbringen, aus einem Oszillator (5) bestehen, dessen Ausgang mit dem Eingang des Umsetzers (I) verbunden ist.

8. Steuerschaltung einer elektronischen Einrichtung, insbesondere einer elektronischen Schaltuhr, die eine durch einen der Ansprüche 1 bis 7 definierte Stromdetektorschaltung (1) beinhaltet, und in welcher die Kippschaltung über einen Schalter (2) an den Klemmen der Speisequelle der elektronischen Einrichtung verbunden ist, wobei der Ausgang des Komparators (4) mit dem Steuer-Eingang der Einrichtung verbunden ist, und der Schalter parallel zur Wechselspannungsquelle mit hoher interner Impedanz geschaltet ist.

0 141 698